# EUROPEAN PATENT APPLICATION

(11) **EP 4 300 178 A1**
(43) Date of publication of application: **03.01.2024**
(21) Application number: 22182267.9
(22) Date of filing: 30.06.2022
(51) Int. Cl.: G02F 1/1335, G02F 1/11, G02F 1/33, G03F 7/00

(54) **ELECTRICAL CROSSTALK CANCELLATION IN ACOUSTOOPTICAL MODULATORS**

(71) Applicant: MYCRONIC AB, 183 03 Täby (SE)
(72) Inventor: NUR, Ismail, 171 45 Solna (SE); STENSTRÖM, Pontus, 184 92 Åkersberga (SE); SVENSSON, Anders, 192 73 Sollentuna (SE); KARAWAJCZYK, Andrzej, 117 36 Stockholm (SE)
(74) Representative: AWA Sweden AB

(57) **Abstract**

A method for operating a multichannel acousto-optical modulator comprises obtaining (S20) of print data for a multitude of channels of the multichannel acousto-optical modulator. Radio-frequency signals for each of the multitude of channels are modulated (S30) based on the print data. The modulated radio-frequency signals are provided (S40) to the respective transducers of the multichannel acousto-optical modulator via electrical input connectors. The modulation of radio-frequency signals comprises, for at least one channel, crosstalk cancellation (S32). Therein, a modulated radio-frequency signal is compensated by a modulated radio-frequency signal of at least an electrically adjacent channel among the electrical input connectors, scaled by a predetermined factor and phase shifted by a predetermined phase difference. A method for calibrating a multichannel acousto-optical modulator, a control unit for a multichannel acousto-optical modulator and a pattern generator are also presented.

## Description

### TECHNICAL FIELD

The present technology relates in general to pattern printing and in particular to devices and methods for pattern printing using acousto-optical modulators.

### BACKGROUND

In the field of pattern printing, multiple channels are often used, typically for increasing the total printing speed. Several channels thereby have to be modulated simultaneously. One approach to manage such a multichannel modulation is to utilize acousto-optical modulators (AOM). Acousto-optic modulation is commonly used in laser scanners, providing a reasonable compromise between cost, speed, and efficiency. An AOM uses sound waves within a crystal to create a diffraction grating. As the power of the applied RF signal is varied, the amount of diffracted light varies proportionally. Acousto-optic multi-channel modulators allow multiple beams to be modulated independently by integrating an array of transducers with a single acousto-optic crystal.

One problem occurring by using a single common acousto-optic crystal is that there is a risk for cross-talk between the channels. "Crosstalk" may refer to acoustic crosstalk and/or electric crosstalk. Acoustic crosstalk takes place within the acousto-optic crystal, as interference between different acoustic waves. The electrical crosstalk may take place all the way from the source of the modulation signal, via the connection cables, and at the acousto-optical crystal itself. The electric crosstalk may furthermore be capacitive (electrostatic) and/or inductive (electromagnetic).

The problem of acoustic cross-talk has been addressed in different ways. One approach is disclosed in the published international patent application WO 2020/120725 A1 in which application of different frequencies to adjoining transducers was introduced.

Furthermore, an often-used approach for reducing some electrical cross-talk is to arrange the electrical input connectors of the channels that are adjacent on the crystal far away from each other. One approach has been to divide the AOM channels into two groups that are well separated in opposite sides of the device. This way, the cross-talk between physically adjacent channels on the crystal is reduced. However, there is still an unavoidable electrical cross-talk between channels that are not physically adjacent on the crystal but electrically adjacent, e.g. in the electrical connectors.

### SUMMARY

A general object of the present technology is to provide improved cross-talk reduction in devices and methods for acousto-optical modulation for multibeam pattern printing.

The above object is achieved by methods and devices according to the independent claims. Preferred embodiments are defined in dependent claims.

In general words, in a first aspect, method for operating a multichannel acousto-optical modulator comprises obtaining of print data for a multitude of channels of the multichannel acousto-optical modulator. Radio-frequency signals for each of the multitude of channels are modulated based on the print data. The modulated radio-frequency signals are provided to the respective transducers of the multichannel acousto-optical modulator via electrical input connectors. The modulation of radio-frequency signals comprises, for at least one channel, crosstalk cancellation. Therein, a modulated radio-frequency signal is compensated by a modulated radio-frequency signal of at least an electrically adjacent channel among the electrical input connectors, scaled by a predetermined factor and phase shifted by a predetermined phase difference.

In a second aspect, a method for calibrating a multichannel acousto-optical modulator comprises operating one channel of a multichannel acousto-optical modulator with a modulated radio-frequency signal. Another channel of the multichannel acousto-optical modulator is operated with the modulated radio-frequency signal scaled by a factor and phase-shifted by a phase difference. The intensity passing through this other channel of the multichannel acousto-optical modulator is measured. A factor and a phase giving a lowest intensity are determined as a predetermined factor and a predetermined phase difference. This predetermined factor and this predetermined phase difference are to be used for crosstalk cancellation between the two tested channels of the multichannel acousto-optical modulator.

In a third aspect, a control unit for a multichannel acousto-optical modulator comprises an input, a modulator arrangement, and a multichannel output. The input is configured for obtaining print data for a multitude of channels of the multichannel acousto-optical modulator. The modulator arrangement has a multichannel modulator control for modulating radio-frequency signals for each of the multitude of channels based on the obtained print data. The multichannel output is configured for providing the modulated radio-frequency signals to respective transducers of the multichannel acousto-optical modulator via electrical input connectors. The modulator arrangement is configured for, for at least one channel, providing crosstalk cancellation giving a modulated radio-frequency signal that is compensated by a modulated radio-frequency signal of at least an electrically adjacent channel among the electrical input connectors, scaled by a predetermined factor and phase shifted by a predetermined phase difference.

In a fourth aspect, a pattern generator comprising a multichannel acousto-optical modulator and a control unit for the multichannel acousto-optical modulator according to the third aspect.

One advantage with the proposed technology is that electrical cross-talk becomes significantly reduced. Other advantages will be appreciated when reading the detailed description.

### BRIEF DESCRIPTION OF THE DRAWINGS

The invention, together with further objects and advantages thereof, may best be understood by making reference to the following description taken together with the accompanying drawings, in which:
FIG. 1 illustrates schematically one embodiment of a pattern generator;
FIG. 2 illustrates schematically an embodiment of connections to an acousto-optical modulator;
FIG. 3 is an image illustrating electrical cross-talk between electrically adjacent channels;
FIG. 4 is an image illustrating partially cancelled electrical cross-talk between electrically adjacent channels;
FIG. 5 is an image illustrating fully cancelled electrical cross-talk between electrically adjacent channels;
FIG. 6 is a schematic illustration of an embodiment of a control unit for a multichannel acousto-optical modulator;
FIG. 7 is a flow diagram of steps of an embodiment of a method for calibrating a multichannel acousto-optical modulator;
FIG. 8 is a flow diagram of steps of an embodiment of a method for operating a multichannel acousto-optical modulator;
FIG. 9 is a flow diagram of steps of an embodiment of a cross-talk cancellation step;
FIG. 10 illustrates schematically an embodiment of a signal compensation arrangement;
FIG. 11 is a flow diagram of steps of another embodiment of a cross-talk cancellation step;
FIG. 12 illustrates schematically another embodiment of a signal compensation arrangement; and
FIG. 13 is a schematic illustration of another embodiment of a control unit for a multichannel acousto-optical modulator.

### DETAILED DESCRIPTION

Throughout the drawings, the same reference numbers are used for similar or corresponding elements.

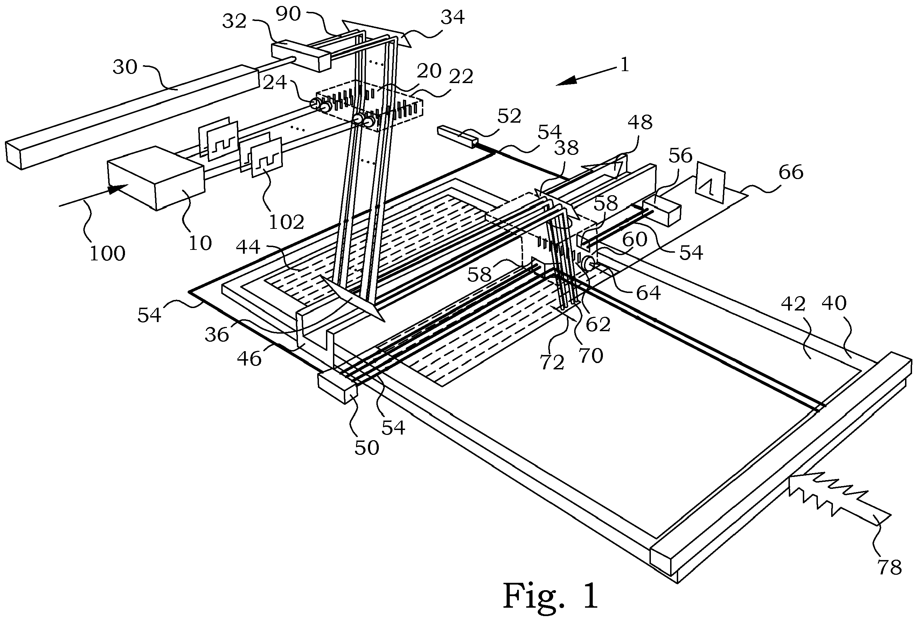

For a better understanding of the proposed technology, it may be useful to begin with a brief overview of a model system of a pattern generator 1, as illustrated by Figure 1. This embodiment of a pattern generator 1 is just an example of a system in which the present technology can be applied. The present technology may be used in any pattern generator using a multiple-channel acousto-optic modulator.

A laser beam is generated by a laser device 30. A Diffractive Optical Element (DOE) 32 splits the laser beam into a number of separate beams 90. A set of mirrors 34, 36, 38 and other optical elements direct the separate beams 90 to irradiate a light-sensitive target 42 at a substrate holder 40, to create a pattern 44 of exposures in the light-sensitive target 42. Each lens, mirror, optical crystal, etc. has some error, giving an energy spread. Print data 100 is provided to a control unit 10 for a multichannel acousto-optical modulator 20.

In the acousto-optical modulator 20, transducers 24 are used for creating acoustic waves through an acousto-optical crystal 22. Depending on the interaction between the acoustic waves and the separate laser beams 90 within the acousto-optical crystal 22, the separate laser beams 90 can be switched on and off in registry with the moving of the separate laser beams 90 over the light-sensitive target 42, thereby giving rise to the requested pattern.

The control unit 10 provides modulated radio-frequency signals 102 based on the print data to respective transducers 24 of the multichannel acousto-optical modulator 20 via electrical input connectors.

The separate laser beams 90 are moved over the light-sensitive target by several mechanisms. A Y-interferometer 50 utilizes laser beams 54 from a laser source 52 to determine the position of the separate laser beams 90 in a Y direction. An X-interferometer 56 is analogously determining the position in an X direction. Mirrors 58 at a movable printing head are used for this purpose. The printing head in an X-carriage is movable along an X-bridge 46 in the X-direction, as indicated by the arrow 48, and the substrate holder 40is movable stepwise in the Y-direction relative to the X-bridge 46 as indicate by the arrow 78. The X-carriage thus scans in the X direction (scan strips). During the X-carriage return stroke, the Y-stage carrying the substrate holder 40 moves one step length (scan strip width). A microsweeping is also available in the Y direction by sweeping the separate laser beams 90 as indicated by the arrow 72, thereby moving the irradiation spots 70 of the separate laser beams 90. The microsweeping is in this embodiment achieved by an acousto-optic deflector 60, having an acousto-optical crystal 62. A transducer 64 is provided with a sweep signal 66, that is coordinated with the other motions and with the print data 100. The exposure is thus made by writing several microsweeps in one scan strip. The AOD deflector crystal 62 generates a sweep for all separate beams 90 together and controls power and linearity over the sweep.

The printed pattern 44 on the light-sensitive target 42 thus depends on that the separate laser beams 90 are given the right modulation in agreement with the microsweeping and other movement action of the printing head. The AOM modulator crystal 22 controls the power for each separate beam 90 and converts pattern data 100 to exposure light. The present technology is focused on the control unit 10 for the multichannel acousto-optical modulator 20 and to methods therefore.

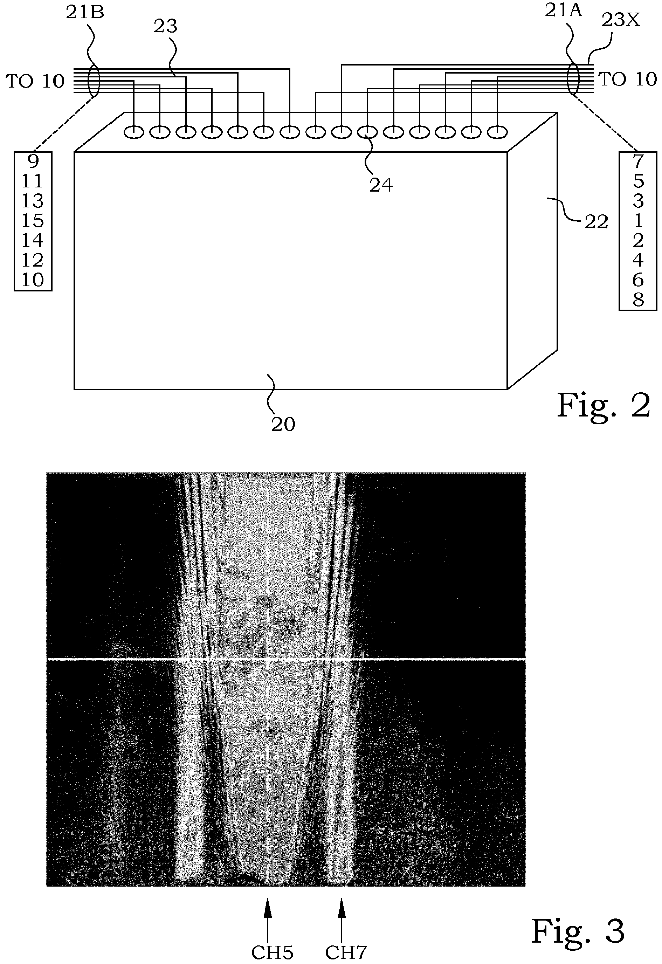

Figure 2 illustrates schematically an embodiment of an AOM 20. This AOM 20 may e.g. be used in a pattern generator as illustrated in Figure 1. In this particular embodiment, the AOM 20 comprises 15 channels. Each channel is defined by a respective transducer 24 mechanically connected to the acousto-optical crystal 22 for enabling a transfer of acoustic waves into the acousto-optical crystal 22. Depending on e.g. the frequency of the acoustic waves, light that passes perpendicular to the waves, i.e. horizontally in the figure, may be influenced. Thereby, it is possible to switch on and switch off the light beams. Each transducer 24 defines a channel of the AOM 20, and each of these channels may thereby be controlled more or less independently of each other. A separate single-frequency control signal to each transducer 24 determines the modulation of one single light beam through the AOM 20.

This approach operates in general quite good. However, there is some cross-talk between the channels. One way to avoid cross-talk between adjacent channels in the AOM crystal 22 is to place electrical input connectors of the channels that are adjacent on the crystal are usually placed far away from each other. In the figure, it can be seen that the transducers are connected by two connectors 21A, 21B, well separated in opposite sides of the device, having 8 and 7, respectively, individual channels 23 each. In one of the connectors 21A, managing a first group of channels 23, the order of the channel connectors is 7, 5, 3, 1, 2, 4, 6, and 8, as indicated in the box at the right side. The numbers refer to the actual mechanical position at the AOM crystal 22. Since the channel numbers indicate how the channels are placed on the crystal, channel 1 is physically adjacent to 2, 2 is physically adjacent to 3 and so on. The order of the channels 23 of the group of connector 21B is analogously 9, 11, 13, 15, 14, 12, and 10, as indicated in the box at the left side. In such a way, the electrical crosstalk between physically adjacent channels is reduced. This is due to that the connectors of the channels are positioned according to the order indicated above. So for example channel 7 is electrically adjacent to 5, 5 to 3 and 7, 3 to 1 and 5, 1 to 2 and 3, 2 to 1 and 4, 4 to 2 and 6, and 6 to 4 and 8, and 8 to 6. The same applies for the other group.

The way the channels are positioned reduces crosstalk between adjacent channels on the crystal, but instead unavoidably introduces electrical crosstalk between channels that are not adjacent on the crystal but electrically adjacent. It was thus found that if only one channel was controlled to admit the light to pass the AOM, and all surrounding channels were turned off, there was still a certain amount of light passing the channels that are electrically adjacent. This is illustrated in the picture of Figure 3, where light passing the different channels are detected.

In this experiment an optical plane wave was sent through the modulator crystal and an RF signal was applied only to one of the modulator channels, in this example channel 5. An imaging system was provided to image the generated acoustic wave inside the crystal onto a camera sensor. This was done by filtering out the 0^{th} diffraction order and letting through to the camera only the 1^{st} diffraction order. When analyzing the image, it was clearly seen that besides the acoustic wave of channel 5, CH5, acoustic waves from channels 3, CH3, and 7, CH7, were also visible. These correspond to the electrically adjacent channels to channel 5, CH5. In the figure, it is also possible to see another acoustic wave of much lower intensity corresponding to channel 1, which is electrically adjacent to channel 3, CH3. The reason these acoustic waves are present is because part of the energy of the radio-frequency signal sent to channel 5, CH5, couples to the electrical circuits of the adjacent channels reaching the corresponding transducers which then generate waves in the crystal. It can also be noted that in the physically adjacent channel between channels CH5 and CH7 no light was detected.

According to the ideas of the present technology, this electrical cross-talk would be possible to cancel out by adding a cancelling signal to the original intended signal before sending it to the AOM. This cancelling signal is a scaled-down and phase-shifted copy of the signal of an electrically adjacent channel. If the channel has two electrically adjacent channels, one respective cancelling signal can be added.

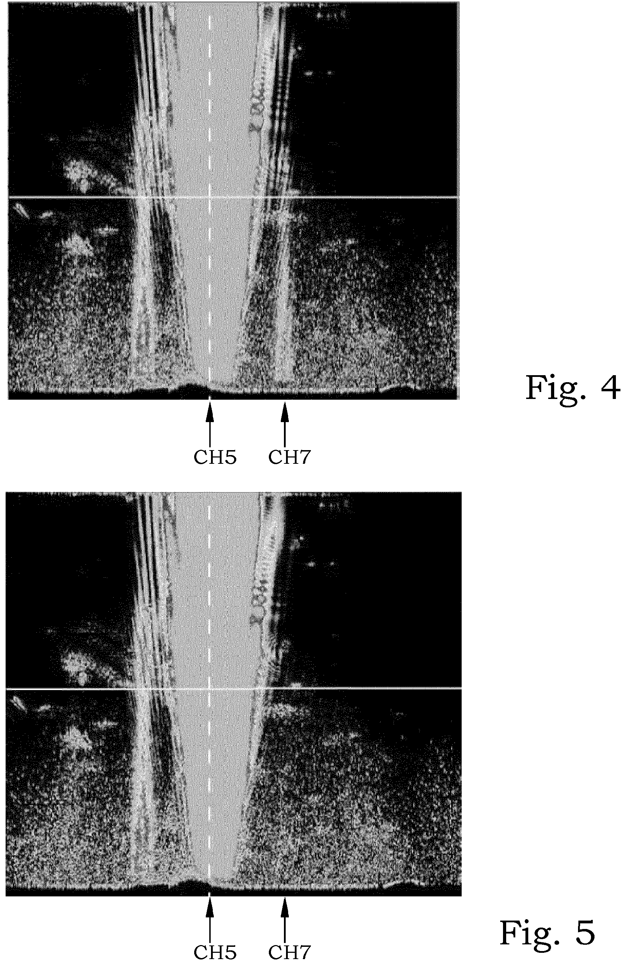

Figure 4 is an image of a situation similar to Figure 3, but with a cancelling signal added in channel CH7 comprising a copy of the CH5 signal, amplitude scaled to 1.7 % (0.028 % power) and phase shifted 203 degrees. The intensity in the CH7 has decreased significantly. The phase shift was furthermore varied, and a largest cancellation was in this particular case found at a phase shift of 211 degrees. Theoretically, if all connectors are exactly the same, e.g. in length, constitution etc., the best cancellation would occur at 180 degrees. However, due to differences between the connectors in the actual setup, there might be a small phase shift between the particular electrically adjacent channels, in this case 31 degrees.

The same test was then repeated, however, with a constant phase shift of 211 degrees, whereas the scaling instead was varied. At an amplitude scaling of 2,9% (0.085 % power), the light through channel CH7 essentially vanished, as is illustrated in Figure 5. The result was the same independently of how the signal in channel CH5 was constituted, as long as the cancelling signal was a scaled and phase -shifted copy thereof.

This shows that the electrical cross-talk is possible to eliminate. Since the cross-talk conditions in a device are constant during operation, the cross-talk cancelling parameters, being the phase shift and the scaling factor, are the same for each pair of channels. It is thus possible to measure and calibrate each individual device for cancellation of electrical cross-talk.

The proposed method thus leads to complete cancellation of the electrical crosstalk between electrically adjacent channels. This method will cancel crosstalk even where pure phase-control approaches fail, e.g. when the wanted signal has zero amplitude and the cross-talking signal has maximum amplitude.

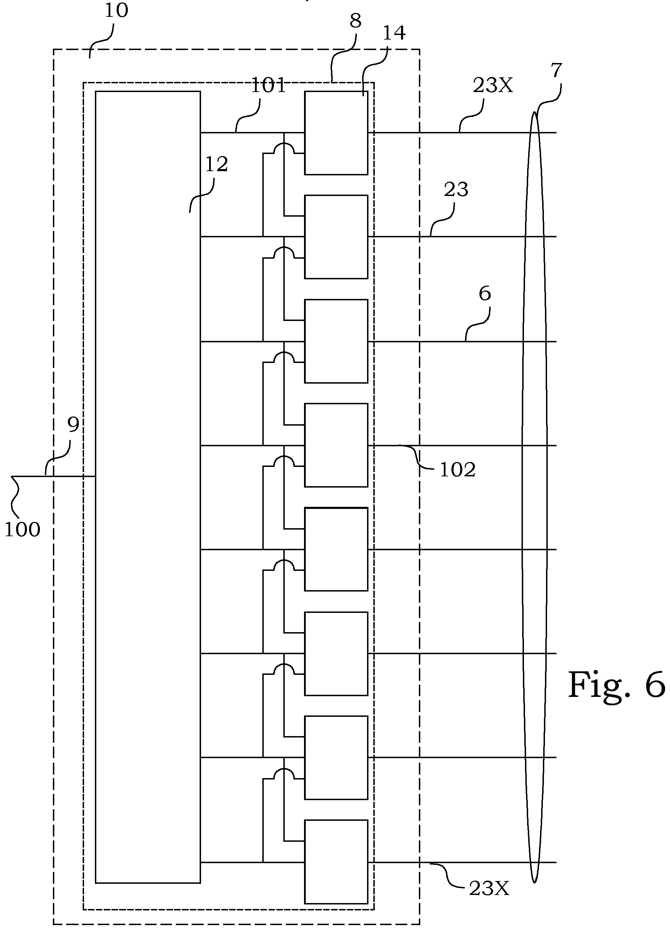

Figure 6 illustrates schematically a control unit 10 for a multichannel acousto-optical modulator. An input 9 is configured for obtaining print data 100 for a multitude of channels 23 of the multichannel acousto-optical modulator. A modulator arrangement 8 has a multichannel modulator control 12 for modulating radio-frequency signals 101 for each of the multitude of channels based on the obtained print data 100.

The modulator arrangement 8 is configured for, for at least one channel 23, providing crosstalk cancellation giving a modulated radio-frequency signal that is compensated by a modulated radio-frequency signal of at least an electrically adjacent channel among the electrical input connectors, scaled by a predetermined factor and phase shifted by a predetermined phase difference. This compensation is added to the modulated radio-frequency signals 101 forming compensated radio-frequency signals 102. This is typically performed in a respective signal compensation arrangement 14 for each channel.

A multichannel output 7 is configured for providing the modulated and compensated radio-frequency signals 102 to respective transducers of the multichannel acousto-optical modulator via electrical input connectors 6.

Preferably, the modulator arrangement 8 is configured for performing the crosstalk cancellation for all channels 23 of the electrical input connectors 6.

Preferably, the modulator arrangement 8 is configured for providing crosstalk cancellation, except for an electrically outermost channel 23X, giving a modulated radio-frequency signal 102 that is compensated by a modulated radio-frequency signal of two electrically adjacent channel among the electrical input connectors scaled by a respective predetermined factor and a respective phase shifted by a predetermined phase difference.

Different, more detailed embodiments will be presented further below.

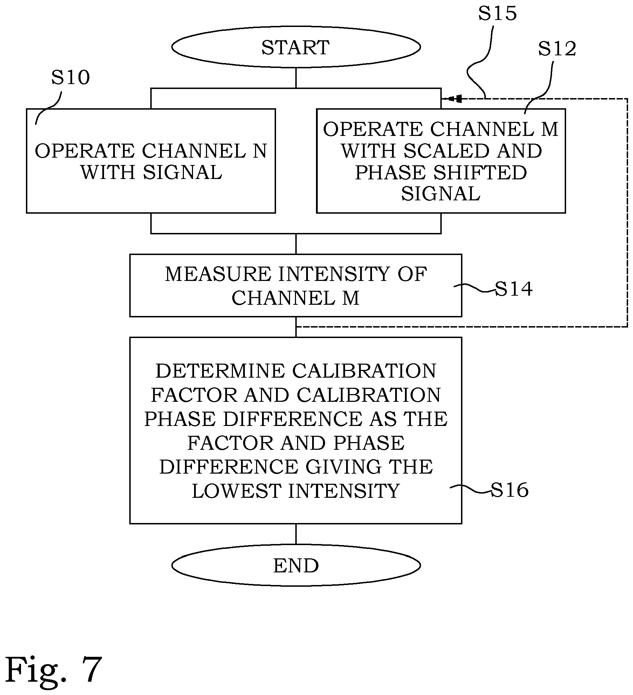

Figure 7 illustrates a flow diagram of steps of an embodiment of a method for calibrating a multichannel acousto-optical modulator. In step S10, one channel, here denoted as channel N, of a multichannel acousto-optical modulator is operated with a modulated radio-frequency signal. In the simultaneous step S12, another channel, here denoted as channel M, of the multichannel acousto-optical modulator is operated with the modulated radio-frequency signal scaled by a factor and phase-shifted by a phase difference.

In step S14, an intensity passing through the other channel of the multichannel acousto-optical modulator, i.e. channel M, is measured. In step S16, a factor and a phase difference giving a lowest intensity is determined. This is typically performed by repeating the steps S12 and S14, as indicated by the dotted arrow S15, with different scale factors and phase shifts. These determined factor and phase difference giving the lowest intensity are assigned as a predetermined factor and a predetermined phase difference for the channel pair N and M, to be used for crosstalk cancellation between the two tested channels N and M of the multichannel acousto-optical modulator.

Preferably, the predetermined factor and the predetermined phase difference are determined for each pair of electrically adjacent channels.

Even if the electrical cross-talk with electrically non-adjacent channels are extremely small, this principle is of course also applicable to all pairs of channels. Therefore, in one embodiment, the predetermined factor and the predetermined phase difference are determined for each pair of channels. If the factor is very small, this is an indication of that the electrical cross-talk also is very small and may be an indication of that cancellation between such channels might not be necessary. The predetermined factor and predetermined phase difference between the different pairs of channels may then be used in the operation of a multichannel acousto-optical modulator.

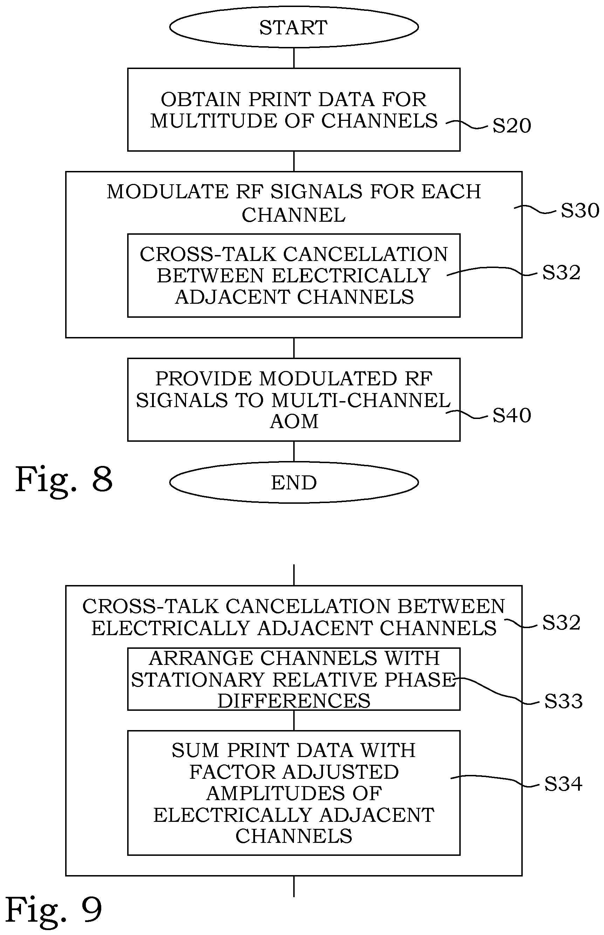

Figure 8 is a flow diagram of steps of an embodiment of a method for operating a multichannel acousto-optical modulator. In step S20, print data for a multitude of channels of the multichannel acousto-optical modulator is obtained. In step S30, radio-frequency signals are modulated for each of the multitude of channels based on the print data. The step S30 of modulating radio-frequency signals in turn comprises crosstalk cancellation S32, for at least one channel. Thereby, a modulated radio-frequency signal is compensated by a modulated radio-frequency signal of at least an electrically adjacent channel among the electrical input connectors, scaled by a predetermined factor and phase shifted by a predetermined phase difference.

In step S40, the modulated radio-frequency signals are provided to respective transducers of the multichannel acousto-optical modulator via electrical input connectors.

Preferably, the crosstalk cancellation is performed for all channels of the electrical input connectors.

It is also preferred that crosstalk cancellation is performed for all electrically adjacent channels. In most cases, the channels have two electrically adjacent channels, whereby compensation for electrical cross-talk from both these electrically adjacent channels are performed. For the channels associated with the connectors provided at the sides of the connectors, i.e. for the outermost channels, there is only one electrically adjacent channel and the compensation for electrical cross-talk is the performed only for one electrically adjacent channel. Therefore, the crosstalk cancellation preferably gives, except for an electrically outermost channel, a modulated radio-frequency signal that is compensated by a modulated radio-frequency signal of two electrically adjacent channels among the electrical input connectors scaled by a respective predetermined factor and a respective phase shifted by a predetermined phase difference.

The above described cross-talk cancellation can be implemented in different ways. It can be realized that the exact, absolute phase of a modulated signal to the multichannel acousto-optical modulator is arbitrary. The operation of a channel of the multichannel acousto-optical modulator does only depend on the frequency applied signal. Thus, applying a phase shift of a signal provided to a single channel of the multichannel acousto-optical modulator will not alter the modulation properties of the channel. The modulator arrangement may then be designed in such a way that each channel is planned with a certain phase difference with respect to electrically adjacent channels. If this phase difference is equal to the measured calibrated predetermined phase shift, a simple setup for the signal compensation arrangement can be utilized. Since the basic phase shift between the different channels already is set to the predetermined phase shift, a simple addition of an amplitude proportional to a signal of an electrically adjacent channel will automatically achieve the intended phase difference.

Figure 9 is a part flow diagram illustrating an embodiment of the step S32 of cross-talk cancellation between electrically adjacent channels. In step S33, the channels are arranged with stationary relative phase difference to the electrically adjacent channel(s) among the electrical input connectors. This stationary relative phase difference is equal to the respective predetermined phase difference. In step S34, a print data amplitude of each channel is summed with print data amplitudes of the electrically adjacent channel scaled with the predetermined factor. In this way, by RF modulation with the stationary relative phase differences will give a total channel signal that comprises cancellation signals with appropriate phase differences relative the electrically adjacent channels.

As an example, a simplified approach could be the following. The data channels sum up the main signal and scaled adjacent signals and provide them for RF modulation, typically in a so-called delivery board. The delivery board has the appropriate phase differences set. In the setup of the embodiment of Figure 2, in an ideal case, all electrically adjacent channels are arranged with a phase difference of 180 degrees, as in Table 1:

**Table 1: Ideal channel phases, in physical order.**

| | | | | | | | | | | | | | | |
|---|---|---|---|---|---|---|---|---|---|---|---|---|---|---|
| 1 | 2 | 3 | 4 | 5 | 6 | 7 | 8 | 9 | 10 | 11 | 12 | 13 | 14 | 15 |
| 180 | 0 | 0 | 180 | 180 | 0 | 0 | 180 | 0 | 0 | 180 | 180 | 0 | 0 | 180 |

By arranging them in electrical order, the phase differences between electrically adjacent channels become obvious, according to Table 2.

**Table 2: Ideal channel phases, in electrical order.**

| | | | | | | | | | | | | | | | |
|---|---|---|---|---|---|---|---|---|---|---|---|---|---|---|---|
| 7 | 5 | 3 | 1 | 2 | 4 | 6 | 8 | | 9 | 11 | 13 | 15 | 14 | 12 | 10 |
| 0 | 180 | 0 | 180 | 0 | 180 | 0 | 180 | | 0 | 180 | 0 | 180 | 0 | 180 | 0 |

In a realistic case the phase differences will not be always 180, as was seen in the experiments mentioned above, so for example if channel 5 needs to be at 200 degrees below channel 7 and 170 deg above channel 3 then the table will have to change to (together with other experimentally determined phase shifts):

**Table 3: Calibrated channel phases, in physical order.**

| | | | | | | | | | | | | | | |
|---|---|---|---|---|---|---|---|---|---|---|---|---|---|---|
| 1 | 2 | 3 | 4 | 5 | 6 | 7 | 8 | 9 | 10 | 11 | 12 | 13 | 14 | 15 |
| 180 | 3 | 350 | 172 | 160 | 359 | 0 | 186 | 0 | 347 | 189 | 172 | 21 | 1 | 184 |

In electrical order, the shifts then become:

**Table 4: Calibrated channel phases, in electrical order.**

| | | | | | | | | | | | | | | | |
|---|---|---|---|---|---|---|---|---|---|---|---|---|---|---|---|
| 7 | 5 | 3 | 1 | 2 | 4 | 6 | 8 | | 9 | 11 | 13 | 15 | 14 | 12 | 10 |
| 0 | 160 | 350 | 180 | 3 | 172 | 359 | 186 | | 0 | 189 | 21 | 184 | 1 | 172 | 347 |

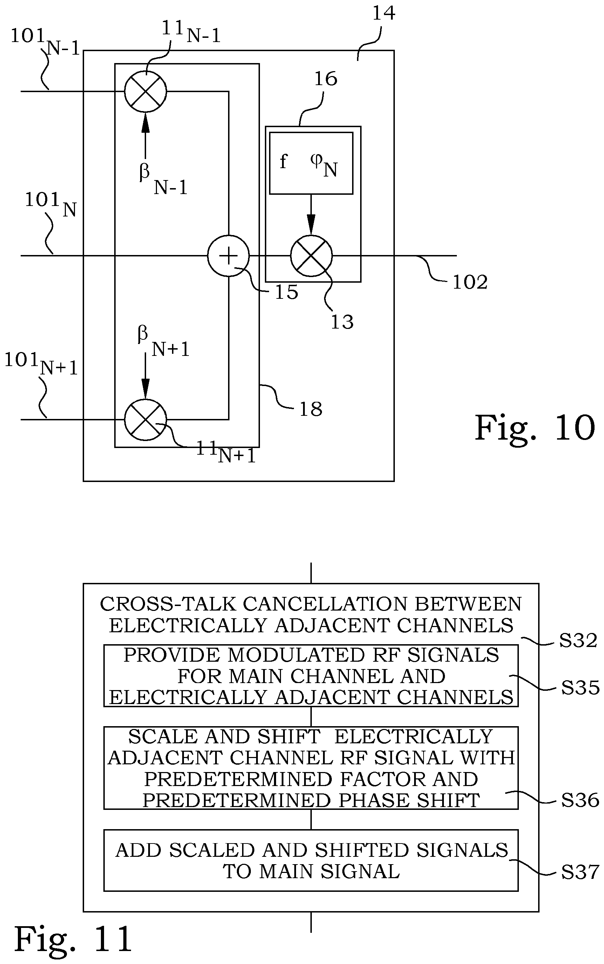

Figure 10 illustrates schematically an embodiment of a signal compensation arrangement 14. Print data 100 for three electrically adjacent channels, 101_{N-1}, 101_{N}, and 101_{N+1}, is provided at inputs to the signal compensation arrangement 14. In an adding section 18, the print data 101_{N-1} is multiplied in a multiplier 11_{N-1} with a scale factor β_{N-1}. Similarly, the print data 101_{N+1} is multiplied in a multiplier 11_{N+1} with a scale factor β_{N+1}. The two scaled print data and the print data 101_{N} are summed in a summer 15 into a compensated print data. In other words, in the adding section 18, a print data amplitude of each channel is summed with print data amplitudes of the electrically adjacent channel scaled with the predetermined factor;

In a modulator 13 of a phase shifter 16, the compensated print data is RF modulated with a frequency f and with a phase ϕ_{N}. The RF modulated signal 102 is provided at the output for being connected to a channel N of the multichannel acousto-optical modulator, via a connector in which channels N-1 and N+1 are electrically adjacent. In other words, the phase shifter 16 is configured for arranging the channels with a stationary relative phase difference to the electrically adjacent channel among the electrical input connectors that is equal to the respective predetermined phase difference.

Alternatively, the implementation can be done entirely in the delivery board. In such a case, the delivery board has to store three times the normal data.

Figure 11 illustrates a flow diagram of an embodiment of the step S32 of cross-talk cancellation between electrically adjacent channels. In Step S35, a modulated radio-frequency signal according to print data of a channel and a modulated radio-frequency signal according to print data of at least one other channel among the electrical input connectors are provided. In step S36, the modulated radio-frequency signal according to print data of the at least one other channel is scaled with the respective predetermined factor and the modulated radio-frequency signal according to print data of the at least one other channel is phase-shifted with the respective predetermined phase difference. In step S37, the modulated radio-frequency signal according to print data of a channel and the scaled and phase-shifted modulated radio-frequency signal according to print data of the at least one other channel are added, which gives the crosstalk-cancelled modulated radio-frequency signal to be provided to the respective transducers.

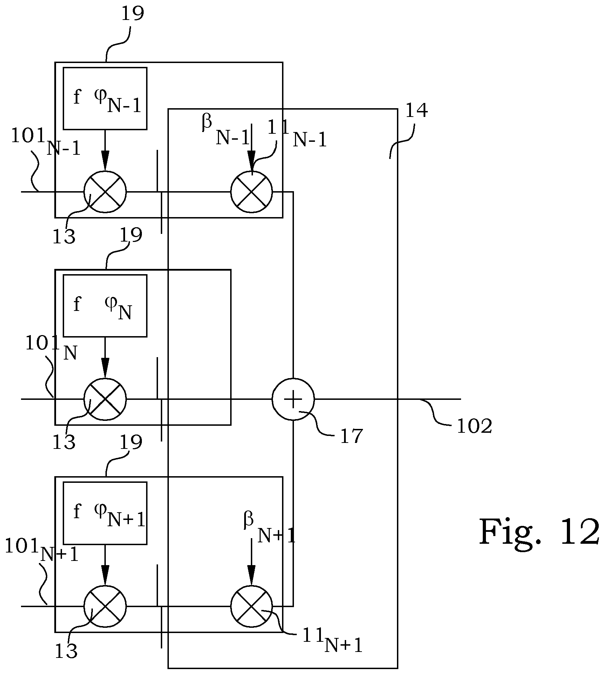

Figure 12 illustrates schematically an embodiment of a signal compensation arrangement 14. Compensation bridges 19 are connected to outputs of the multichannel modulator control 12 and configured to scale a modulated radio-frequency signal according to print data of a channel with the respective predetermined factor and to phase-shift the modulated radio-frequency signal according to print data the channel with the respective predetermined phase difference. Signal adders 17 are connected to one or more of the compensation bridges 19 and are configured to add scaled and phase-shifted modulated radio-frequency signal according to print data of the channel from the one or more compensation bridge to a modulated radio-frequency signal according to print data of another channel. A respective output of the signal adders 17, providing the crosstalk-cancelled modulated radio-frequency signal, is connected to a respective one of the transducers via the electrical input connectors.

As mentioned above, the cancellation of electrical cross-talk may also be generalized to more channels than the electrically adjacent channels. In general, the cross-talk is reduced considerably for each channel that separates the two interfering channels. It is therefore unlikely that more than the two closest channels on each side will give cross-talk that is large enough to be compensated. However, theoretically it can be performed for all channels.

In other words, in one embodiment, the crosstalk cancellation gives a modulated radio-frequency signal that is compensated by a modulated radio-frequency signal of more than two channels among the electrical input connectors scaled by a respective predetermined factor and a respective phase shifted by a predetermined phase difference.

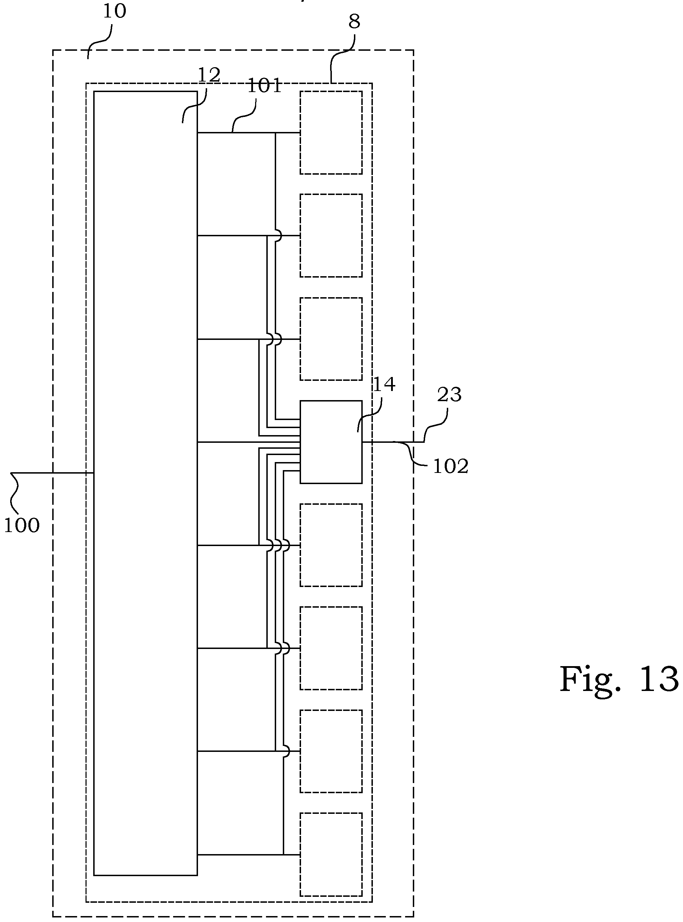

Figure 13 illustrates schematically an embodiment, where cross-talk from more than two channels on each side is compensated. In other words, the modulator arrangement 8 is configured for providing crosstalk cancellation giving a modulated radio-frequency signal that is compensated by a modulated radio-frequency signal of at least an electrically adjacent channel among the electrical input connectors, scaled by a predetermined factor and phase shifted by a predetermined phase difference.

The present ideas of cross-talk compensation has been proven to give an essentially complete cancellation of electrical crosstalk between electrically adjacent channels. Furthermore, there are implementations that are readily achieved without having to introduce hardware modifications. Necessary modifications are possible to implement in only software/firmware.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

## Claims

1. A method for operating a multichannel acousto-optical modulator (20), comprising the steps of:
- obtaining (S20) print data (101) for a multitude of channels (23) of said multichannel acousto-optical modulator (20);
- modulating (S30) radio-frequency signals (102) for each of said multitude of channels (23) based on said print data (101); and
- providing (S40) said modulated radio-frequency signals (102) to respective transducers (24) of said multichannel acousto-optical modulator (20) via electrical input connectors (6),
**characterized in that**
said step of modulating (S20) radio-frequency signals (102) comprises, for at least one channel (23), crosstalk cancellation (S32) wherein a modulated radio-frequency signal is compensated by a modulated radio-frequency signal of at least an electrically adjacent channel (23) among said electrical input connectors, scaled by a predetermined factor (β) and phase shifted by a predetermined phase difference (ϕ).

2. The method according to claim 1, **characterized in that** said crosstalk cancellation (S32) is performed for all channels (23) of said electrical input connectors (6).

3. The method according to claim 1 or 2, **characterized in that** said crosstalk cancellation (S32) gives, except for an electrically outermost channel (23X), a modulated radio-frequency signal (102) that is compensated by a modulated radio-frequency signal of two electrically adjacent channels (23) among said electrical input connectors (6) scaled by a respective predetermined factor (β) and a respective phase shifted by a predetermined phase difference (ϕ).

4. The method according to any of the claims 1 to 3, **characterized in that** said crosstalk cancellation (S32) comprises the steps of:
- arranging (S33) said channels (23) with a stationary relative phase difference to said electrically adjacent channel (23) among said electrical input connectors (6) equal to said respective predetermined phase (ϕ) difference; and
- summing (S34) a print data amplitude of each channel (23) with print data amplitudes of said electrically adjacent channel (23) scaled with said predetermined factor (β).

5. The method according to any of the claims 1 to 3, **characterized in that** said crosstalk cancellation (S32) gives a modulated radio-frequency signal that is compensated by a modulated radio-frequency signal of more than two channels (23) among said electrical input connectors scaled by a respective predetermined factor (β) and a respective phase shifted by a predetermined phase difference (ϕ).

6. The method according to any of the claims 1, 2, 3 or 5, **characterized in that** said crosstalk cancellation (S32) comprises the steps of:
- providing (S35) a modulated radio-frequency signal according to print data (101) of a channel (23) and a modulated radio-frequency signal according to print data (101) of at least one other channel (23) among said electrical input connectors (6);
- scaling (S36) said modulated radio-frequency signal (101) according to print data of said at least one other channel (23) with said respective predetermined factor (β) and phase-shifting said modulated radio-frequency signal (101) according to print data of said at least one other channel (23) with said respective predetermined phase difference (ϕ);
- adding (S37) said modulated radio-frequency signal according to print data of a channel (23) and said scaled and phase-shifted modulated radio-frequency signal according to print data of said at least one other channel (23), giving said crosstalk-cancelled modulated radio-frequency signal (102) to be provided to said respective transducers.

7. A method for calibrating a multichannel acousto-optical modulator (20), comprising the steps of:
- operating (S10) one channel (23) of a multichannel acousto-optical modulator (20) with a modulated radio-frequency signal;
- operating (S12) another channel (23) of said multichannel acousto-optical modulator (20) with said modulated radio-frequency signal scaled by a factor and phase-shifted by a phase difference;
- measuring (S14) an intensity passing through said another channel (23) of said multichannel acousto-optical modulator (20); and
- determining (S16) a factor and a phase difference giving a lowest intensity as a calibration factor and a calibration phase difference to be used for crosstalk cancellation between said two tested channels (23) of said multichannel acousto-optical modulator.

8. The method according to claim 7, **characterized in that** said calibration factor and said calibration phase difference are determined for each pair of electrically adjacent channels (23).

9. The method according to claim 7 or 8, **characterized in that** said calibration factor and said calibration phase difference are determined for each pair of channels (23).

10. A control unit (10) for a multichannel acousto-optical modulator (20), comprising:
- an input (9) for obtaining print data (100) for a multitude of channels (23) of said multichannel acousto-optical modulator (20);
- a modulator arrangement (8) having a multichannel modulator control (12) for modulating radio-frequency signals (102) for each of said multitude of channels (23) based on said obtained print data (100); and
- a multichannel output (7) for providing said modulated radio-frequency signals (102) to respective transducers of said multichannel acousto-optical modulator (20) via electrical input connectors (6);
wherein said modulator arrangement (8) is configured for, for at least one channel (23), providing crosstalk cancellation giving a modulated radio-frequency signal (102) that is compensated by a modulated radio-frequency signal of at least an electrically adjacent channel (23) among said electrical input connectors (6), scaled by a predetermined factor (β) and phase shifted by a predetermined phase difference (ϕ).

11. The control unit according to claim 10, **characterized in that** said modulator arrangement (8) is configured for performing said crosstalk cancellation for all channels (23) of said electrical input connectors (6).

12. The control unit according to claim 10 or 11, **characterized in that** said modulator arrangement (8) is configured for providing crosstalk cancellation, except for an electrically outermost channel (23X), giving a modulated radio-frequency signal (102) that is compensated by a modulated radio-frequency signal of two electrically adjacent channel (23) among said electrical input connectors scaled by a respective predetermined factor (β) and a respective phase shifted by a predetermined phase difference (ϕ).

13. The control unit according to any of the claims 10 to 12, **characterized in that** said modulator arrangement (8) comprises:
- an adding section (18), in which a print data (101_{N}) amplitude of each channel (23) is summed with print data amplitudes (101_{N-1}, 101_{N+1}) of said electrically adjacent channel (23) scaled with said predetermined factor (β); and
- a phase shifter (16), configured for arranging said channels (23) with a stationary relative phase difference to said electrically adjacent channel (23) among said electrical input connectors (6) that is equal to said respective predetermined phase difference (ϕ).

14. The control unit according to any of the claims 10 to 12, **characterized in that** said modulator arrangement (8) is configured for providing crosstalk cancellation giving a modulated radio-frequency signal (102) that is compensated by a modulated radio-frequency signal of at least an electrically adjacent channel (23) among said electrical input connectors (6), scaled by a predetermined factor (β) and phase shifted by a predetermined phase difference (ϕ).

15. The control unit according to any of the claims 10, 11, 12 or 14, **characterized in that** said modulator arrangement (8) comprises a signal compensation arrangement having:
- compensation bridges (19) connected to outputs of said multichannel modulator control (12) and configured to scale a modulated radio-frequency signal according to print data of a channel (23) with said respective predetermined factor (β) and to phase-shift said modulated radio-frequency signal according to print data said channel (23) with said respective predetermined phase difference (ϕ); and
- signal adders (17) connected to one or more of said compensation bridge (19), configured to add scaled and phase-shifted modulated radio-frequency signal according to print data of said channel (23) from said one or more compensation bridge (19) to a modulated radio-frequency signal according to print data of another channel (23);
whereby a respective output of said signal adders (17), providing said crosstalk-cancelled modulated radio-frequency signal (102), is connected to a respective said transducer (24) via said electrical input connectors (6).

16. A pattern generator (1) comprising a multichannel acousto-optical modulator (20) and a control unit (10) for the multichannel acousto-optical modulator (20) according to any of the claims 10 to 15.
